# EUROPÄISCHE PATENTSCHRIFT

(11) **EP 1 921 909 B1**
(45) Veröffentlichungstag und Bekanntmachung des Hinweises auf die Patenterteilung: **22.08.2012**
(21) Anmeldenummer: 07021364.0
(22) Anmeldetag: 02.11.2007
(51) Int. Cl.: H05K 7/14

(54) **Leistungsmodul**
Power module
Module de puissance

(30) Priorität: 08.11.2006 DE 102006052607
(43) Veröffentlichungstag der Anmeldung: 14.05.2008
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A- 1 037 351
- DE-A1- 19 630 173
- JP-A- 8 145 019

## Beschreibung

Die Erfindung betrifft ein Leistungsmodul mit einem Modul-Plattenelement und einem becherförmigen Gehäuse, wobei der Becherrand des Gehäuses abgestuft mit einem umlaufenden erhöhten Aussenrand und einem gegen den Aussenrand zurück versetzten, vertieften Innenrand ausgebildet ist, wobei das Modul-Plattenelement mit seinem innenseitigen Rand an Erhebungen anliegt.

Ein derartiges Leistungsmodul ist in der DE 196 30 173 A1 beschrieben.

Die JP 08 145019 A beschreibt ein Leistungsmodul mit einem Haltesystem für ein Modul-Plattenelement, das mittels eines Klemmverfahrens zwischen einem oberen und einem unteren Gehäuse befestigt wird. Das untere Gehäuse weist eine Erhebung auf, auf der das Modul-Plattenelement angeordnet ist.

Aus der EP 1 037 351 A1 wird ein weiteres Halterungssystem offenbart. Das System umfasst einen Halterahmen zur Festlegung eines Bauteils an eine Wand. Eine Öffnung im Halterahmen ermöglicht eine verdrehsichere Befestigung an der Wand, wobei als Verdrehschutz eine in einem Abstand zu der einen Öffnung angeordnete Kralle an den Halterahmen vorgesehen ist.

Bei bekannten Leistungsmodulen ist infolge von nicht zu vermeidenden Verbiegungen der Modul-Plattenelemente bei der Herstellung der Leistungsmodule ein Produktionsausschuss infolge eines Verdrehens der Modul-Plattenelemente in Bezug zum zugehörigen Gehäuse oftmals nicht vermeidbar.

Deshalb liegt der Erfindung die Aufgabe zugrunde, ein Leistungsmodul der eingangs genannten Art zu schaffen, bei welchem ein Produktionsausschuss durch Verdrehen des Modul-Plattenelements in Bezug zum Gehäuse auf einfache Weise vermieden wird.

Diese Aufgabe wird bei einem Leistungsmodul der eingangs genannten Art erfindungsgemäss dadurch gelöst, dass am Aussenrand des Becherrandes des Gehäuses voneinander beabstandet Verdrehsicherungsnoppen ausgebildet sind. Diese Verdrehsicherungsnoppen besitzen eine Höhenabmessung, die an das Überstandsmass des Modul-Plattenelements, mit dem das Modul-Plattenelement über den Aussenrand des Becherrandes des Gehäuses übersteht, angepasst ist.

Dabei können die Verdrehsicherungsnoppen eine Höhenabmessung besitzen, die geringfügig kleiner ist als das Überstandsmass des Modul-Plattenelements in Bezug zum Aussenrand des Becherrandes des Gehäuses. Eine andere Möglichkeit besteht darin, dass die Verdrehsicherungsnoppen eine Höhenabmessung besitzen, die geringfügig grösser ist als das Überstandsmass des Modul-Plattenelements in Bezug zum Aussenrand des Becherrandes des Gehäuses.

Insbesondere bei einer Ausbildung der zuletzt genannten Art ist es zweckmässig, wenn die Verdrehsicherungsnoppen eine bestimmte Nachgiebigkeit besitzen, d.h. entsprechend zusammendrückbar sind.

Die Verdrehsicherungsnoppen können pyramidenstumpfförmig oder kegelstumpfförmig ausgebildet sein. Eine andere Möglichkeit besteht beispielsweise darin, die Verdrehsicherungsnoppen quaderförmig zu gestalten.

Unabhängig von der speziellen Form der Verdrehsicherungsnoppen ist es bevorzugt, wenn diese innenseitig mit einer Innenfläche ausgebildet sind, die mit der Abstufungsfläche zwischen dem Aussenrand und dem Innenrand des Becherrandes des Gehäuses ebenflächig fluchtet, weil durch eine derartige Ausbildung ein unerwünschtes Verdrehen des mit Leistungshalbleiter-Bauelementen und mit weiteren elektrischen und/oder elektronischen Bauelementen bestückten Modul-Plattenelements in Bezug zum becherförmigen Gehäuse bei der Herstellung des Leistungsmoduls zuverlässig verhindert und folglich ein Produktionsausschuss vermieden wird.

Weitere Einzelheiten, Merkmale und Vorteile ergeben sich aus der nachfolgenden Beschreibung zweier in der Zeichnung schematisch und nicht massstabgetreu abschnittweise und teilweise aufgeschnitten verdeutlichter Ausführungsbeispiele des erfindungsgemässen Leistungsmoduls.

Es zeigen-:
- Figur 1: eine erste Ausführungsform des Leistungsmoduls,
- Figur 2: in einer der Figur 1 ähnlichen Darstellung eine zweite Ausführungsform des Leistungsmoduls, und
- Figur 3: eine perspektivische Ansicht einer Ausbildung des Gehäuses eines Leistungsmoduls.

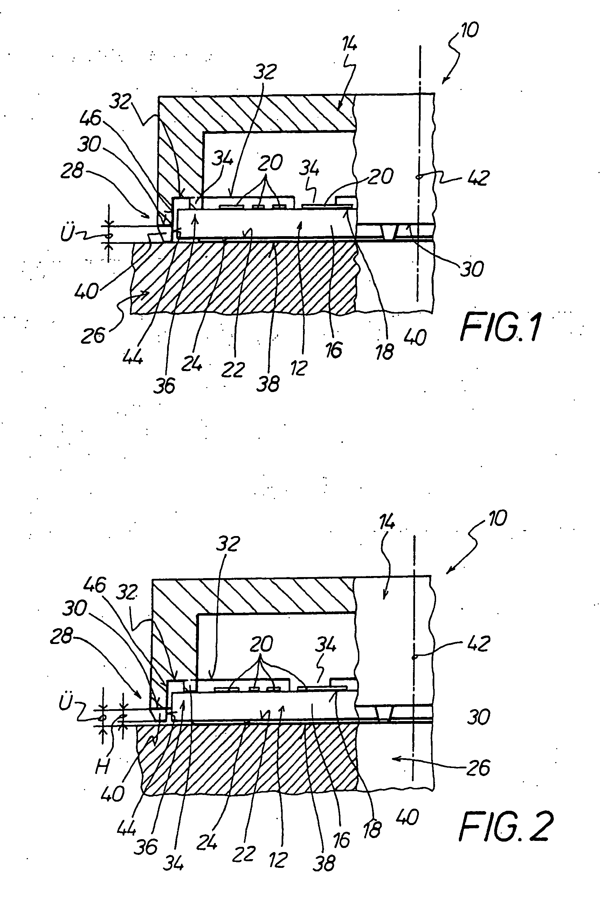

Figur 1 zeigt abschnittweise und teilweise aufgeschnitten ein Leistungsmodul 10 mit einem Modul-Plattenelement 12 und einem becherförmigen Gehäuse 14. Das Modul-Plattenelement 12 weist ein plattenförmiges Substrat 16, beispielsweise aus einer Sinterkeramik, wie Aluminiumoxid, auf.

An der Innenseite 18 des Substrats 16 sind Leiterbahnstrukturen 20 vorgesehen, an welchen nicht dargestellte Leistungshalbleiter-Bauelemente sowie elektrische und/oder elektronische Bauelemente kontaktiert sind. An der der Innenseite 18 gegenüberliegenden Aussenseite 22 des plattenförmigen Substrats 16 ist eine Metallisierung 24 vorgesehen, die eine Wärmeableitung vom plattenförmigen Substrat 16 zu einem abschnittweise gezeichneten Kühlkörper 26 bildet.

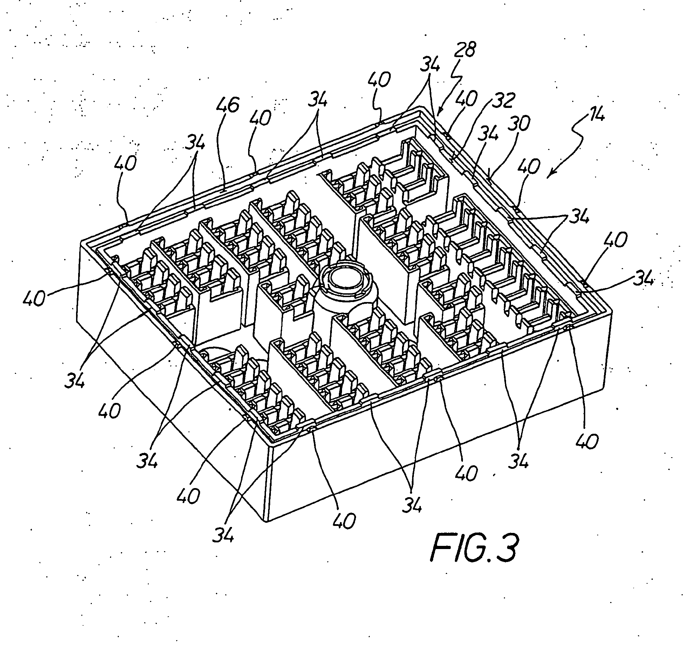

Das becherförmige Gehäuse 14 weist - wie auch aus Figur 3 ersichtlich ist-einen umlaufenden Becherrand 28 auf. Der Becherrand 28 ist abgestuft mit einem umlaufenden erhöhten Aussenrand 30 und einem gegen den Aussenrand 30 zurück versetzten vertieften Innenrand 32 ausgebildet. Der Innenrand 32 ist mit voneinander und vom Aussenrand 30 beabstandeten Erhebungen 34 ausgebildet. Das Modul-Plattenelement 12, d.h. sein plattenförmiges Substrat 16, liegt im zusammengebauten Zustand des Leistungsmoduls 10 mit seinem innenseitigen Rand 36 an den Erhebungen 34 an.

Das Modul-Plattenelement 12 steht mit seiner durch die Metallisierung 24 bestimmten Aussenfläche 38 über den Aussenrand 30 des Gehäuses 14 um ein bestimmtes Überstandsmass U über.

Um ein unerwünschtes Verdrehen des Modul-Plattenelements 12 in Bezug zum becherförmigen Gehäuse 14 bei der Montage des Leistungsmoduls 10, d.h. bei seiner Befestigung am Kühlkörper 26, zu vermeiden, sind am Aussenrand 30 des Becherrandes 28 des Gehäuses 14 voneinander beabstandet Verdrehsicherungsnoppen 40 ausgebildet (sh. auch Figur 3). Die Verdrehsicherungsnoppen 40 stehen vom Aussenrand 30 in die gleiche Richtung weg wie die am Innenrand 32 ausgebildeten Erhebungen 34.

Eine Verdrehung des Modul-Plattenelements 12 in Bezug zum becherförmigen Gehäuse 14, wie sie oben erwähnt worden ist, könnte sich - ohne die Ausbildung des becherförmigen Gehäuses 14 mit den Verdrehsicherungsnoppen 40 - bei der Verschraubung des Leistungsmoduls 10 mit dem Kühlkörper 26 ergeben. Eine solche an sich übliche Verschraubung ist in Figur 1 durch die strichpunktierte Linie 42 schematisch angedeutet.

Bei dem in Figur 1 schematisch verdeutlichten Ausführungsbeispiel besitzen die Verdrehsicherungsnoppen 40 eine Höhenabmessung, die gleich gross oder geringfügig grösser ist als das Überstandsmass U des Modul-Plattenelements 12 in Bezug zum Aussenrand 30 des Becherrandes 28 des Gehäuses 14.

Dem gegenüber verdeutlicht die Figur 2 eine Ausführungsform, bei der die Verdrehsicherungsnoppen 40 eine Höhenabmessung H besitzen, die geringfügig kleiner ist als das Überstandsmass U des Modul-Plattenelements 12 in Bezug zum Aussenrand 30 des Becherrandes 28 des Gehäuses 14.

Gleiche Einzelheiten sind in Figur 2 mit denselben Bezugsziffern wie in Figur 1 bezeichnet, so dass es sich erübrigt, in Verbindung mit Figur 2 alle Einzelheiten noch einmal detailliert zu beschreiben.

Die Verdrehsicherungsnoppen 40 können beispielsweise pyramidenstumpfförmig oder kegelstumpfförmig ausgebildet sein. Die Verdrehsicherungsnoppen 40 können auch als kleine Quader gestaltet sein. Unabhängig von der jeweiligen Ausbildung der Verdrehsicherungsnoppen 40 sind diese innenseitig mit einer Innenfläche 44 ausgebildet, die mit der Abstufungsfläche 46 zwischen dem Aussenrand 30 und dem Innenrand 32 des Becherrandes 28 des Gehäuses 14 ebenflächig fluchtet.

### Bezugsziffernliste:

- 10: Leistungsmodul
- 12: Modul-Plattenelement (von 10)
- 14: becherförmiges Gehäuse (von 10 für 12)
- 16: plattenförmiges Substrat (von 12)
- 18: Innenseite (von 16)
- 20: Leiterbahnstrukturen (an 18)
- 22: Aussenseite (von 16)
- 24: Metallisierung (an 22 für 26)
- 26: Kühlkörper
- 28: Becherrand (von 14)
- 30: Aussenrand (von 28)
- 32: Innenrand (von 28)
- 34: Erhebungen (an 32)
- 36: innenseitiger Rand (von 12 bzw. 16)
- 38: Aussenfläche (von 12 bzw. 24)
- 40: Verdrehsicherungsnoppen (an 30)
- 42: strichpunktierte Linie /Verschraubung (von 10 mit 26)
- 44: Innenfläche (von 40)
- 38: Abstufungsfläche (zwischen 30 uns 32)

## Patentansprüche

1. Leistungsmodul (10) mit einem Modul-Plattenelement (12) und einem becherförmigen Gehäuse (14), wobei der Becherrand (28) des Gehäuses (14) abgestuft mit einem umlaufenden erhöhten Aussenrand (30) und einem gegen den Aussenrand (30) zurück versetzten, vertieften Innenrand (32) ausgebildet ist, wobei das Modul-Plattenelement (12) mit seinem innenseitigen Rand (36) an Erhebungen (34) anliegt und mit seiner Aussenfläche (38) über den Aussenrand (30) des Gehäuses (14) um ein bestimmtes Überstandsmass (U) übersteht,
**dadurch gekennzeichnet,**
**dass** am Aussenrand (30) des Becherrandes (28) des Gehäuses (14) voneinander beabstandet Verdrehsicherungsnoppen (40) ausgebildet sind, die in die gleiche Richtung wie die am Innenrand (32) ausgebildeten Erhebungen (34) vom Aussenrand wegstehen.

2. Leistungsmodul nach Anspruch 1,
**dadurch gekennzeichnet,**
**dass** die Verdrehsicherungsnoppen (40) eine Höhenabmessung (H) besitzen, die an das Überstandsmass (U) des Modul-Plattenelements (12) in Bezug zum Aussenrand (30) des Becherrands (28) des Gehäuses (14) angepasst ist.

3. Leistungsmodul nach Anspruch 1 oder 2,
**dadurch gekennzeichnet,**
**dass** die Verdrehsicherungsnoppen (40) eine Höhenabmessung (H) besitzen, die geringfügig kleiner ist als das Überstandsmass (U) des Modul-Plattenelements (12) in Bezug zum Aussenrand (30) des Becherrands (28) des Gehäuses (14).

4. Leistungsmodul nach Anspruch 1 oder 2,
**dadurch gekennzeichnet,**
**dass** die Verdrehsicherungsnoppen (40) eine Höhenabmessung (H) besitzen, die gleich gross oder geringfügig grösser ist als das Überstandsmass (U) des Modul-Plattenelements (12) in Bezug zum Aussenrand (30) des Becherrands (30) des Gehäuses (14).

5. Leistungsmodul nach-Anspruch 4,
**dadurch gekennzeichnet,**
**dass** die Verdrehsicherungsnoppen (40) eine bestimmte Nachgiebigkeit besitzen.

6. Leistungsmodul nach einem der Ansprüche 1 bis 5,
**dadurch gekennzeichnet,**
**dass** die Verdrehsicherungsnoppen (40) pyramidenstumpfförmig ausgebildet sind.

7. Leistungsmodul nach einem der Ansprüche 1 bis 5,
**dadurch gekennzeichnet,**
**dass** die Verdrehsicherungsnoppen (40) kegelstumpfförmig ausgebildet sind.

8. Leistungsmodul nach einem der Ansprüche 1 bis 7,
**dadurch gekennzeichnet ,**
**dass** die Verdrehsicherungsnoppen (40) innenseitig mit einer Innenfläche (44) ausgebildet sind, die mit der Abstufungsfläche (46) zwischen dem Aussenrand (30) und dem Innenrand (32) des Becherrandes (28) des Gehäuses (14) ebenflächig fluchtet.

## Claims

1. Power module (10) having a module board element (12) and a cup-shaped housing (14), wherein the cup edge (28) of the housing (14) is stepped with a raised peripheral outer edge (30) and a recessed inner edge (32) set back from the outer edge (30), wherein the module board element (12) abuts by its inside edge (36) against raised portions (34) and protrudes by its outer surface (38) beyond the outer edge (30) of the housing (14) by a given amount (U),
**characterised in that**
at a distance from each other on the outer edge (30) of the cup edge (28) of the housing (14) are formed twist-proof knobs (40) which project away from the outer edge in the same direction as the raised portions (34) formed at the inner edge (32).

2. Power module according to claim 1,
**characterised in that**
the twist-proof knobs (40) have a height (H) which is adapted to the amount (U) by which the module board element (12) protrudes in relation to the outer edge (30) of the cup edge (28) of the housing (14).

3. Power module according to claim 1 or 2,
**characterised in that**
the twist-proof knobs (40) have a height (H) which is slightly smaller than the amount (U) by which the module board element (12) protrudes in relation to the outer edge (30) of the cup edge (28) of the housing (14).

4. Power module according to claim 1 or 2,
**characterised in that**
the twist-proof knobs (40) have a height (H) which is equal to or slightly greater than the amount (U) by which the module board element (12) protrudes in relation to the outer edge (30) of the cup edge (30) of the housing (14).

5. Power module according to claim 4,
**characterised in that**
the twist-proof knobs (40) have a certain flexibility.

6. Power module according to any of claims 1 to 5,
**characterised in that**
the twist-proof knobs (40) are in the shape of truncated pyramids.

7. Power module according to any of claims 1 to 5,
**characterised in that**
the twist-proof knobs (40) are in the shape of truncated cones.

8. Power module according to any of claims 1 to 7,
**characterised in that**
the twist-proof knobs (40) are designed on the inside with an inner surface (44) which is aligned in planar relationship with the stepped surface (46) between the outer edge (30) and the inner edge (32) of the cup edge (28) of the housing (14).

## Revendications

1. Module de puissance (10) comprenant un élément de plaque à module (12) et un boîtier (14) en forme de gobelet, le bord du gobelet (28) du boîtier (14) étant conçu en dégradé avec un bord extérieur (30) périphérique surélevé et un bord intérieur (32) en creux et reculé par rapport au bord extérieur (30), l'élément de plaque à module (12) s'appliquant avec son bord (36) côté intérieur sur des surélévations (34) et dépassant, avec sa surface extérieure (38), du bord extérieur (30) du boîtier (14) d'une cote de saillie (U) définie,
**caractérisé en ce que**
des nopes de blocage anti-torsion (40) sont conçues à distance les unes des autres sur le bord extérieur (30) du bord du gobelet (28) du boîtier (14), lesquelles nopes partent du bord extérieur dans la même direction que les surélévations (34) formées sur le bord intérieur (32).

2. Module de puissance selon la revendication 1,
**caractérisé en ce que**
les nopes de blocage anti-torsion (40) présentent une dimension en hauteur (H) qui est adaptée à la cote de saillie (U) de l'élément de plaque à module (12) par rapport au bord extérieur (30) du bord du gobelet (28) du boîtier (14).

3. Module de puissance selon la revendication 1 ou 2,
**caractérisé en ce que**
les nopes de blocage anti-torsion (40) présentent une dimension en hauteur (H) qui est légèrement inférieure à la cote de saillie (U) de l'élément de plaque à module (12) par rapport au bord extérieur (30) du bord du gobelet (28) du boitier (14).

4. Module de puissance selon la revendication 1 ou 2,
**caractérisé en ce que**
les nopes de blocage anti-torsion (40) présentent une dimension en hauteur (H) qui est identique ou légèrement supérieure à la cote de saillie (U) de l'élément de plaque à module (12) par rapport au bord extérieur (30) du bord de gobelet (30) du boîtier (14).

5. Module de puissance selon la revendication 4,
**caractérisé en ce que**
les nopes de blocage anti-torsion (40) possèdent une souplesse définie.

6. Module de puissance selon l'une des revendications 1 à 5,
**caractérisé en ce que**
les nopes de blocage anti-torsion (40) sont conçues en forme de pyramide tronquée.

7. Module de puissance selon l'une des revendications 1 à 5,
**caractérisé en ce que**
les nopes de blocage anti-torsion (40) sont conçues en forme de cône tronqué.

8. Module de puissance selon l'une des revendications 1 à 7,
**caractérisé en ce que**
les nopes de blocage anti-torsion (40) sont conçues côté intérieur avec une surface intérieure (44), qui est alignée de façon plane avec la surface de gradation (46) entre le bord extérieur (30) et le bord intérieur (32) du bord du gobelet (28) du boîtier (14).
